# EUROPEAN PATENT APPLICATION

(11) **EP 1 830 397 A2**
(43) Date of publication of application: **05.09.2007**
(21) Application number: 07003901.1
(22) Date of filing: 26.02.2007
(51) Int. Cl.: H01L 21/306, H01L 21/02, B08B 3/04, B08B 3/12, H01L 21/205

(54) **Surface treatment method of compound semiconductor substrate, fabrication method of compound semiconductor, compound semiconductor substrate, and semiconductor wafer**

(30) Priority: 02.03.2006 JP 2006056212
(71) Applicant: Sumitomo Electric Industries, Ltd., Osaka-shi, Osaka 541-0041 (JP)
(72) Inventor: Nishiura, Takayuki c/o Itami Works, Itami-shi Hyogo 664-8611 (JP); Okita, Kyoko c/o Itami Works, Itami-shi Hyogo 664-8611 (JP); Horie, Yusuke c/o Itami Works, Itami-shi Hyogo 664-8611 (JP)
(74) Representative: Grünecker, Kinkeldey, Stockmair & Schwanhäusser Anwaltssozietät

(57) **Abstract**

A surface treatment method of a compound semiconductor substrate, a fabrication method of a compound semiconductor, a compound semiconductor substrate, and a semiconductor wafer are provided, directed to reducing the impurity concentration at a layer formed on a substrate by reducing the impurity concentration at the surface of the substrate formed of a compound semiconductor. The compound semiconductor substrate surface treatment method includes a substrate preparation step (S10) and a first washing step (S20). The substrate preparation step (S10) includes the step of preparing a substrate formed of a compound semiconductor containing at least 5 mass % of indium. In the first washing step (S20), the substrate is washed for a washing duration of at least 3 seconds and not more than 60 seconds using washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value.

## Description

### BACKGROUND OF THE INVENTION

### Field of the Invention

The present invention relates to a surface treatment method of a compound semiconductor substrate, a fabrication method of a compound semiconductor, a compound semiconductor substrate, and a semiconductor wafer. More particularly, the present invention relates to a surface treatment method of a compound semiconductor substrate, a fabrication method of a compound semiconductor, a compound semiconductor substrate, and a semiconductor wafer, directed to reducing the surface impurity concentration.

### Description of the Related Art

Substrates formed of Group III-V compound semiconductors are extensively used for a semiconductor laser, LED (Light Emitting Diode), high speed device, and the like by virtue of the light emitting characteristics and high electron mobility. In the fabrication method of a substrate formed of a Group III-V compound semiconductor, surface treatment is generally applied. Such a surface treatment is disclosed in, for example, Japanese Patent Laying-Open No. 5-166785 (Patent Document 1) involving a storing method of a semiconductor wafer, and Japanese Patent Laying-Open No. 7-211688 (Patent Document 2) corresponding to a production of a compound semiconductor substrate.

In the semiconductor wafer storing method disclosed in Patent Document, an InP wafer is cleaned by a mixture of phosphoric acid-hydrogen peroxide-water or a mixed solution of hydrogen fluoride-hydrogen peroxide-water.

In the production of a compound semiconductor substrate disclosed in Patent Document 2, the substrate surface is oxidized, and then immersed in ammonium hydroxide solution, sodium hydroxide solution, phosphoric acid, hydrochloric acid, or hydrofluoric acid.

In the case where the InP (indium phosphorus) is washed with the mixture of phosphoric acid-hydrogen peroxide-water or the mixed solution of hydrogen fluoride-hydrogen peroxide-water mixture disclosed in Patent Document 1, there is a problem that, when an epitaxially-grown layer (epi layer: a layer of epitaxial growth on a cleaned substrate) is provided, impurities such as oxygen will be present at the interface between the substrate and the epi layer. The reason thereof is set forth below. Since P (phosphorus) will be vaporized when InP is heated up to approximately 700°C, the substrate temperature is generally maintained at 700°C during epitaxial growth and during thermal cleaning prior to epitaxial growth. In₂O₃ that is an oxide typical of In (indium) is a high boiling substance exhibiting vaporization at the temperature of 850°C and above. Therefore, In oxides such as In₂O₃ cannot be removed by the general thermal cleaning carried out prior to epitaxial growth. When epitaxial growth is conducted under the state where there is a large amount of In oxides at the surface of the substrate, impurities such as oxygen will be introduced into the epi layer due to the remaining impurities at the surface.

In the case where the substrate is immersed in ammonium hydroxide solution, sodium hydroxide solution, phosphoric acid, hydrochloric acid, or hydrofluoric acid after the substrate surface is oxidized as disclosed in Patent Document 2, In oxides such as In₂O₃ cannot be removed sufficiently, likewise Patent Document 1, since the acid concentration is too low (pH is too high). In the case where the substrate is immersed in hydrochloric acid, local reaction will occur vigorously due to the unevenness of the oxide at the surface or foreign objects adhering to the surface since the acid concentration is too high (pH is too low), leading to the possibility of small concaves and convexes at the surface. Further, oxidation of the substrate surface will increase the In oxides per se, resulting in residues after the In oxide removal step. In other words, it will cause surface deficiency (surface haze). If epitaxial growth is conducted on such a substrate with haze at the surface, impurities will be introduced into the epitaxially grown layer to degrade the product value.

### SUMMARY OF THE INVENTION

In view of the foregoing, an object of the present invention is to provide a surface treatment method of a compound semiconductor substrate, a fabrication method of a compound substrate, a compound semiconductor substrate, and a semiconductor wafer that can have the impurity concentration of a layer deposited on a substrate formed of a compound semiconductor reduced by reducing the impurity concentration at the surface of the substrate.

A surface treatment method of a compound semiconductor substrate of the present invention includes a substrate preparation step, and a first washing step. The substrate preparation step includes the step of preparing a substrate formed of a compound semiconductor containing at least 5 mass % of indium (In). The first washing step includes the step of washing the substrate for a duration of at least 3 seconds and not more than 60 seconds using washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value.

By employing the washing liquid set forth above according to the surface treatment method of a compound semiconductor substrate of the present invention, the impurity concentration of In oxides and the like at the surface of the substrate can be reduced even by a short washing duration. Further, in the event of conducting film deposition on the substrate, the impurity concentration of the grown layer can be reduced since the impurity concentration at the substrate surface is reduced.

Preferably in the surface treatment method of a compound semiconductor substrate set forth above, the pH of the washing liquid is adjusted to at least - 1 and not more than 1.5 in the first washing step. Accordingly, more In oxides can be removed from the substrate surface.

Preferably in the surface treatment method of a compound semiconductor substrate set forth above, the first washing step includes a first rinsing step of rinsing the substrate with deionized water (DIW). Accordingly, adherence of microparticles to the substrate surface can be suppressed.

Preferably in the surface treatment method of a compound semiconductor substrate set forth above, the first rinsing step includes the step of applying ultrasonic waves to the deionized water. Accordingly, adherence of microparticles to the substrate surface can be suppressed.

The surface treatment method of a compound semiconductor substrate set forth above further includes a second washing step of washing the substrate using washing liquid having the pH adjusted to acidity of at least 2 and not more than 6.3 and with an oxidizing agent added.

By setting the pH to at least 2 and not more than 6.3, the surface of the substrate can be set at a stoichiometric state. Accordingly, the small roughness (haze) at the surface of the substrate can be reduced. Further, the washing performance can be improved by using ultra deionized water with an oxidizing agent added as the washing liquid.

Preferably in the surface treatment method of a compound semiconductor substrate set forth above, the washing duration in the second washing step is at least 5 seconds and not more than 60 seconds.

Accordingly, the compound semiconductor substrate can be set at a stoichiometric state to suppress the small roughness at the surface even if the treatment is carried out in a short period of time. Further, the cost of the liquid for the treatment can be reduced and the productivity improved since the treatment can be carried out in a short period of time.

Preferably in the surface treatment method of a compound semiconductor substrate set forth above, the second washing step includes a second rinsing step of rinsing the substrate with deionized water. Accordingly, adherence of microparticles to the substrate surface can be suppressed.

Preferably in the surface treatment method of a compound semiconductor substrate set forth above, the second rinsing step includes the step of applying ultrasonic waves to the deionized water. Accordingly, adherence of microparticles to the substrate surface can be suppressed.

The surface treatment method of a compound semiconductor substrate set forth above preferably includes a pre-washing step of washing the substrate using alkaline washing liquid, prior to the first washing step. By using alkaline washing liquid in the pre-washing step, microparticles can be removed.

Preferably in the surface treatment method of a compound semiconductor substrate set forth above, the pre-washing step includes a wet-cleaning step of rinsing the substrate with deionized water.

By rinsing the substrate with deionized water, unstable reaction such as neutralization reaction can be prevented during acid washing since no alkaline washing liquid remains and disturbance in the effect of acid washing can be eliminated, allowing a shorter acid washing duration.

A fabrication method of a compound semiconductor of the present invention includes the steps of carrying out the surface treatment method of a compound semiconductor substrate set forth above, and a post-treatment step of conducting film deposition on the surface of the substrate after the step of the surface treatment method.

Since film deposition is conducted on a substrate having impurity concentration reduced, the layer of film deposition can have the impurity concentration reduced.

According to a compound semiconductor substrate of the present invention, the compound semiconductor substrate is treated by the surface treatment method of a compound semiconductor substrate set forth above. The proportion of Group III atoms/proportion of Group V atoms is below 1.5 based on XPS (X-ray Photoelectron Spectroscopy) with a photoelectron take-off angle of 10° for the surface of the compound semiconductor substrate.

By setting the proportion of Group III atoms/proportion of Group V atoms to below 1.5 for the substrate, the impurity concentration such as of Si (silicon), C (carbon), O (oxygen) and the like at the surface of the substrate can be reduced. Therefore, the impurity concentration of the layer of film deposition on the substrate can be reduced since impurities are not introduced thereto.

A semiconductor wafer of the present invention includes a substrate of a different type, and a compound semiconductor substrate set forth above, formed on the substrate of the different type.

The impurity concentration such as of Si, C, O, and the like at the surface of a semiconductor wafer can be reduced even for a semiconductor wafer including substrates formed of a plurality of layers of different materials. Since impurities are not introduced into the layer of film deposition on the semiconductor wafer, the impurity concentration thereof can be reduced.

A substrate of a different type implies a substrate based on a material differing from the material of a substrate formed of a compound semiconductor containing at least 5 mass % of indium.

By the washing step of the present invention having the washing liquid and washing duration specified, the impurity concentration at the surface of the substrate formed of a compound semiconductor can be reduced, allowing reduction in the impurity concentration of the layer formed on the substrate.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a flowchart of a substrate surface treatment method according to a first embodiment of the present invention.
Fig. 2 represents the relationship between pH and oxidation-reduction potential E(mV).
Fig. 3 is a schematic sectional view of a compound semiconductor substrate subsequent to a first washing step (S20) of the first embodiment.
Fig. 4 is a schematic sectional view of a semiconductor wafer according to a modification of the first embodiment.
Fig. 5 is a flowchart of a compound semiconductor substrate surface treatment method according to a second embodiment of the present invention.
Fig. 6 is a schematic sectional view of a washing device used in a rinsing step.
Fig. 7 represents the relationship between the ratio of In/P at the substrate surface and impurity concentration subsequent to epitaxial growth.
Fig. 8 represents the haze at the substrate surface subsequent to epitaxial growth.

### DESCRIPTION OF THE PREFERRED EMBODIMENTS

Embodiments and examples of the present invention will be described hereinafter with reference to the drawings. In the drawings, the same or corresponding elements have the same reference characters allotted, and description thereof will not be repeated.

### First Embodiment

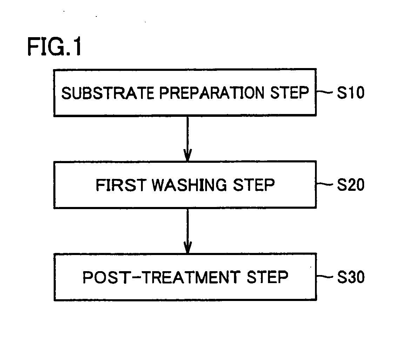

A surface treatment method of a substrate according to a first embodiment of the present invention will be described hereinafter with reference to Fig. 1.

In the substrate surface treatment method (washing method) of the first embodiment, first a substrate preparation step (S10) is conducted. A substrate formed of a compound semiconductor containing at least 5 mass % of indium is prepared. The prepared substrate is not particularly limited as long as it contains at least 5 mass % of indium. For example, a substrate formed of a compound semiconductor such as InP, InAs, InSb, InN, or the like can be used. Further, the substrate may be a bulk crystal, or a thin film formed on a substrate including a bulk crystal and the like.

Then, the first washing step (S20) is conducted. Using washing liquid having a pH of at least - 1 and not more than 3, and an oxidation-reduction potential E (mV) satisfying the relationship of - 0.08333x + 0.750 ≤ E≤ - 0.833x + 1.333, where x is the pH value, the substrate is washed for the duration of at least 3 seconds and not more than 60 seconds.

In the first washing step (S20), the pH of the washing liquid is at least - 1 and not more than 3, preferably at least - 1 and not more than 1.5. If the pH is set smaller than - 1, there is a possibility of the substrate being eroded. If the pH is set higher than 3, impurities such as In oxides at the substrate surface cannot be removed sufficiently. By setting the pH lower than 1.5, impurities such as In oxides can be removed sufficiently from the substrate surface.

Washing liquid is used having the oxidation-reduction potential E (mV) satisfying the relationship of - 0.08333x + 0.750 ≤ E ≤ - 0.833x + 1.333, where x is the pH value. Accordingly, impurities such as In oxides at the substrate surface can be removed sufficiently.

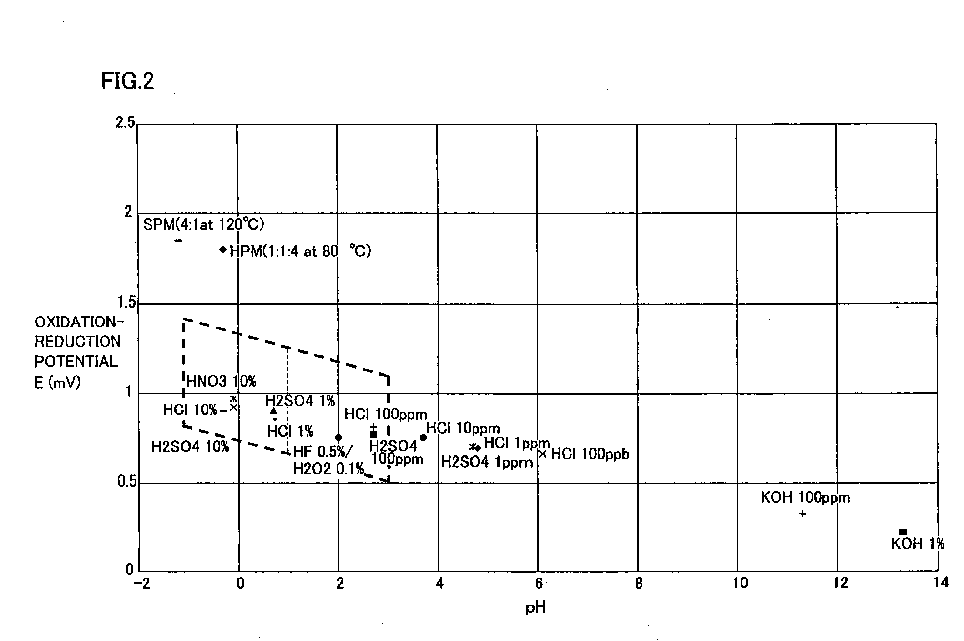

Specifically, the washing liquid in the range of the broken line shown in Fig. 2 can be used. For example, 10% of HNO, 0.01% (equivalent to 100 ppm) to 10% of HCl, 0.01 % (equivalent to 100 ppm) to 10% of H₂SO₄, 0.5% of HF, 0.1% of H₂O₂, and the like can be enumerated for the washing liquid. In Fig. 2, pH (unit: none) is plotted along the horizontal axis, and the oxidation-reduction potential E (mV) is plotted along the vertical axis.

The washing duration is set to at least 3 seconds and not more than 60 seconds, preferably to at least 10 seconds and not more than 30 seconds. If the washing duration is set shorter than 3 seconds, the impurities at the substrate surface cannot be removed sufficiently. By setting the washing duration to at least 10 seconds, the impurities at the substrate surface can be removed sufficiently. If the washing duration is set longer than 60 seconds, the substrate surface will be eroded by the washing liquid. By setting the washing duration to 30 seconds at most, erosion of the substrate surface by the washing liquid can be suppressed. Additionally, the cost of the washing liquid can be reduced and the productivity improved.

The temperature of the washing liquid is preferably, but not particularly limited, to room temperature. By using washing liquid corresponding to room temperature, the facility for surface treatment of the substrate can be simplified.

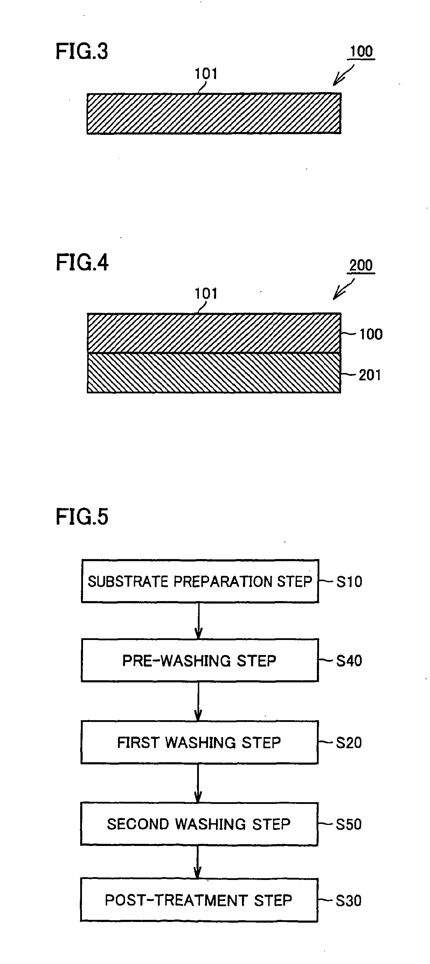

By conducting the first washing step (S20), the compound semiconductor substrate subjected to the surface treatment method of a compound semiconductor substrate of the present invention corresponds to, for example, a compound semiconductor substrate 100, as shown in Fig. 3. Substrate 100 has the proportion of Group III atoms/proportion of Group V atoms set below 1.5 when subjected to XPS analysis with the photoelectron take-off angle of 10° for a surface 101. By setting the proportion value to below 1.5, the impurity concentration such as of Si, C, and O at the substrate surface can be reduced. Such a compound semiconductor substrate 100 is a mirror substrate with extremely low impurity concentration.

The proportion of the atoms set forth above is the proportion of elements present at the surface of substrate 100 subsequent to the first washing step (S20). The proportion of the elements is obtained through measurements taken for a sufficient period of time such that the peak area of the Group V element (for example, P when InP) becomes at least 5 times the difference in area between the crest and trough of the background noise. The number of photelectrons is counted with the angle between the surface of substrate 100 and the analyzer axis in XPS set to 10°. The ratio of the count of the Group III element to the Group V element is corrected based on the sensitivity ratio of the elements for the proportion set forth above. The center of the wafer is taken as the site of analysis.

Then, a post-treatment step (S30) of a film deposition process (epitaxial growth) on the surface of the substrate subjected to the washing step (S20) is conducted. In the post-treatment process (S30), film deposition of forming a predetermined film on the surface of compound semiconductor substrate 100 containing at least 5 mass % of indium is conducted. Preferably, a plurality of elements are formed. In this case, a dividing step such as dicing is conducted to cut the substrate into individual elements after a predetermined construct is formed on the substrate surface. Thus, an element employing a Group III-V compound semiconductor can be obtained. Such an element is mounted on, for example, a lead frame. By wire bonding or the like, a semiconductor device employing the element set forth above can be obtained.

The compound semiconductor obtained by the post-treatment step (S30) does not have impurities introduced into the epi layer during epitaxial growth since the impurity concentration at the surface of the substrate on which film deposition is to be carried out is low. Therefore, a favorable epi layer with low impurity concentration is obtained.

The surface treatment method of a compound semiconductor substrate according to the first embodiment of the present invention includes a substrate preparation step (S10) of preparing a substrate formed of a compound semiconductor containing at least 5 mass % of indium, and a first washing step (S20) of washing the substrate for a duration of at least 3 seconds and not more than 60 seconds using washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value. By using the relevant washing liquid, impurities such as In oxides can be readily dissolved to reduce the impurity concentration at the substrate surface. Further, erosion of the substrate by the washing liquid can be prevented since the washing duration is short. Thus, the impurity concentration at the surface of the substrate formed of a compound semiconductor can be reduced to suppress haze at the surface subsequent to epitaxial growth.

A modification of the first embodiment of the present invention will be described hereinafter. The washing method of the compound semiconductor substrate of the present modification is basically similar to the washing method of the compound semiconductor substrate of the first embodiment in the foregoing, and differs in that a substrate formed of a compound semiconductor containing at least 5 mass % of indium is formed on a substrate of a different type.

Specifically, in the substrate preparation step (S10), a substrate formed of a compound semiconductor containing at least 5 mass % of indium that is to be formed on a substrate of a different type is prepared. The substrate of a different type may include, for example, silicon (Si), gallium arsenide (GaAs), sapphire (Al₂O₃), silicon carbide (SiC), and the like. Following formation of a compound semiconductor containing at least 5 mass % of indium on the substrate of a different type, the surface is subjected to CMP (Chemical Mechanical Polishing) to obtain a surface of high quality, reduced in unevenness.

As a result of the first washing step (S20), a semiconductor wafer subjected to the surface treatment method of a compound semiconductor substrate is obtained. A semiconductor wafer 200 of the present modification includes a substrate 201 of a different type and substrate 100, as shown in Fig. 4. In semiconductor wafer 200, the (proportion of Group III atoms)/(proportion of Group V atoms) is below 1.5 based on XPS analysis with the photoelectron take-off angle of 10° for surface 101 of the semiconductor wafer.

Semiconductor wafer 200 according to a modification of the first embodiment includes a substrate 201 of a different type, and a compound substrate 100 subjected to the surface treatment method of a compound semiconductor substrate set forth above, formed on substrate 201. Accordingly, the impurity concentration at surface 101 of semiconductor wafer 200 layered on substrate 201 can be reduced.

### Second Embodiment

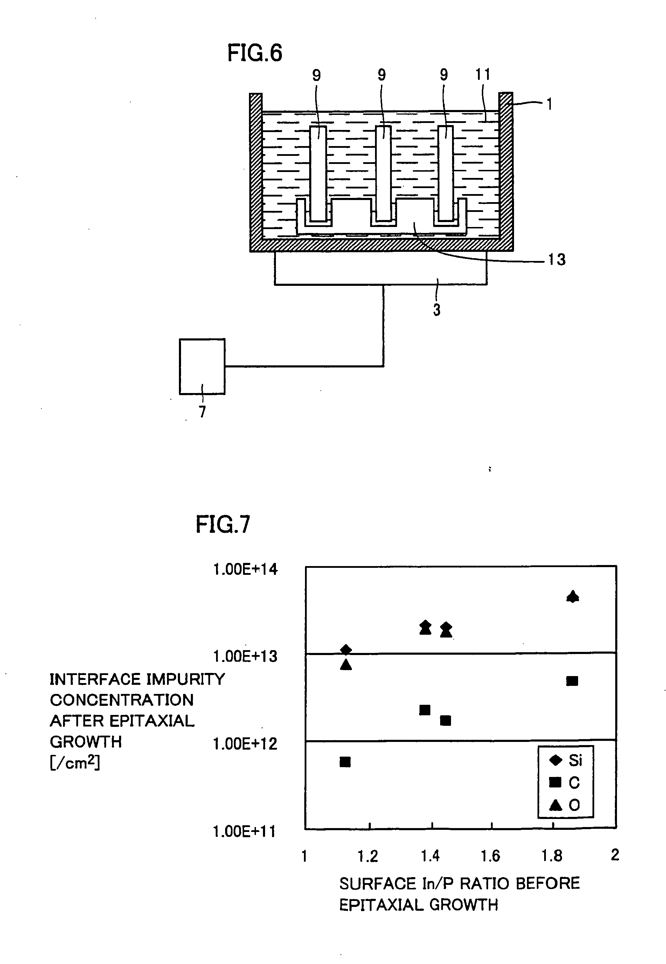

A surface treatment method of a substrate according to a second embodiment of the present invention will be described hereinafter with reference to Fig. 5.

The substrate surface treatment method of the second embodiment is basically based on the substrate surface treatment method of the first embodiment, and differs from the compound semiconductor substrate surface treatment method of the first embodiment in that a pre-washing step (S40) and a second washing step (S50) are further included.

In the pre-washing step (S40), the substrate is washed using alkaline washing liquid, prior to the first washing step (S20). The pre-washing step (S40) may include an agent washing step, a wet-cleaning step (deionized water rinsing step), and a drying step. The agent washing step and wet-cleaning step (deionized water rinsing step) may be repeated for a plurality of times, as necessary.

In the pre-washing step (S40), an arbitrary method can be employed to remove impurities from the surface of the substrate formed of a compound semiconductor. For example, alkaline washing liquid can be used in the pre-washing step (S40). The alkaline washing liquid is preferably any one selected from the group consisting of sodium hydroxide (NaOH) solution, potassium hydroxide (KOH) solution, ammonium hydroxide solution, and amines. The usage of alkaline washing liquid is attributed to the advantage of removing microparticle and the like from the surface.

In the second washing step (S50), the substrate is washed using washing liquid having the pH adjusted to the acidity of at least 2 and not more than 6.3 and with an oxidizing agent added, after the first washing step (S20). The washing liquid is preferably ultra deionized water (washing liquid including ultra deionized water having the pH adjusted to the acidity of at least 2 and not more than 6.3 and with an oxidizing agent added). This second washing step (S50) can reduce the haze at the surface subsequent to epitaxial growth. Therefore, conducting the second washing step allows the advantage of reducing the impurity concentration at the interface between the epitaxial layer and substrate and also the advantage of reducing haze subsequent to epitaxial growth.

In view of adjusting the pH of the washing liquid, it is preferable to include at least one selected from the group consisting of inorganic acid, organic acid, and water-soluble acid gas in the ultra deionized water. As the organic acid, formic acid, acetic acid, oxalic acid, lactic acid, malic acid, citric acid and the like, for example, is preferably used. The pH of the washing liquid can be readily adjusted to approximately 4 due to the low acidity of the organic acid. As the water-soluble acid gas, carbon dioxide gas, hydrogen chloride gas (HC1), hydrogen fluoride gas (HF) or the like is preferably used.

As the oxidizing agent, hydrogen peroxide solution, for example, can be used. The concentration of the oxidizing agent is, for example, at least 5 ppm and not more than 1 mass %, more preferably at least 10 ppm and not more than 0.5 mass %. If the concentration of the oxidizing agent is lower than 5 ppm, the washing performance is degraded. If the concentration of the oxidizing agent becomes higher than 1 mass %, reaction with the oxides, organics, microparticles, and the like at the surface may occur, leading to the possibility of local unevenness at the surface.

The washing duration is preferably, but not particularly limited to, at least 5 seconds and not more than 60 seconds. By conducting the treatment in a short period of time, the cost of the washing liquid can be reduced and the productivity improved.

The temperature of the washing liquid is preferably, but not particularly limited to room temperature. The room temperature is advantageous from the standpoint of simplifying the facility for the substrate surface treatment.

To summarize, the compound semiconductor substrate surface treatment method of the second embodiment further includes a pre-washing step (S40) of washing the substrate using alkaline washing liquid, prior to the washing step (S20), and the pre-washing step (S40) may include a wet-cleaning step (deionized water rinsing step) of rinsing the substrate with deionized water. Therefore, microparticles can be removed using the alkaline washing liquid in the pre-washing step (S40). By using deionized water for rinsing in the rinsing step, the alkaline washing liquid, if used in the pre-washing step, can be washed away by the deionized water to be completely removed. Therefore, the haze at the substrate surface subsequent to epitaxial growth can be reduced.

The surface treatment method further includes a second washing step (S50) of washing the substrate using washing liquid having the pH adjusted to acidity of at least 2 and not more than 6.3 and with an oxidizing agent added, following the washing step (S20). The haze at the substrate surface subsequent to the epitaxial growth can be reduced by setting the pH to at least 2 and not more than 6.3. Further, the addition of an oxidizing agent to the washing liquid allows the washing performance to be improved.

### Third Embodiment

A surface treatment method of a compound semiconductor substrate according to a third embodiment of the present invention will be described with reference to Fig. 5. It is appreciated from Fig. 5 that the compound semiconductor substrate surface treatment method of the third embodiment has a configuration basically similar to that of the compound semiconductor substrate surface treatment method of the second embodiment.

Specifically, the first washing step (S20) and the second washing step (S50) include first and second rinsing steps of washing the substrate with deionized water. In the first and second rinsing steps, ultrasonic waves are applied to the deionized water. For example, the washing liquid is vibrated (or shaken) using an ultrasonic device as shown in Fig. 6, in the first and second rinsing steps. The compound semiconductor substrate surface treatment method is not particularly limited to the application of both the first and second rinsing steps. For example, at least one of the first washing step (S20) and the second washing step (S50) preferably includes the rinsing step of washing the substrate with deionized water (at least one of the first rinsing step and second rinsing step).

More specifically, the first washing step (S20) and the second washing step (S50) may include an agent washing step, rinsing step, and drying step. The agent washing step and rinsing step may be carried out repeatedly, as necessary.

The deionized water is preferably ultra deionized water with resistivity of at least 17.5 MΩ·cm and not more than 18.3 MΩ·cm, for example.

A treatment device employed in the compound semiconductor substrate surface treatment method of the third embodiment will be described with reference to Fig. 6.

Referring to Fig. 6, the treatment device includes a washing tub 1 to hold washing liquid 11 qualified as the rinse agent, an ultrasonic generation member 3 disposed at the bottom of washing tub 1, and a control unit 7 connected to ultrasonic generation member 3 to control the same. Washing liquid 11 is stored in washing tub 1. A holder 13 to hold a plurality of substrates 9 is dipped in washing liquid 11. A plurality of substrates 9 formed of Group III-V compound semiconductor that is the subject of washing are held by holder 13. Ultrasonic generation member 3 is located at the bottom of washing tub 1.

When the substrate is to be washed in accordance with the first and second rinsing steps, predetermined washing liquid 11 is introduced in washing tub 1, and holder 13 together with the relevant substrates 9 is dipped in washing liquid 11. Thus, the surface of substrates 9 can be washed.

At this stage, ultrasonic waves can be generated by ultrasonic generation member 3 under control of control unit 7. Accordingly, ultrasonic waves are applied to washing liquid 11. In response, washing liquid 11 is vibrated to improve the effect of removing impurities and microparticles from substrates 9. Further, by placing washing tub 1 on a shakable member such as an XY stage and move the member in an oscillating manner, washing tub 1 is shaken to stir (shake) washing liquid 11 therein. Alternatively, holder 13 together with substrates 9 may be moved back and forth manually to stir (shake) washing liquid 11. This is advantageous in removing impurities and/or microparticles from substrate 9, similar to the application of ultrasonic waves.

In the substrate surface treatment method of the third embodiment, at least one of the first washing step (S20) and the second washing step (S50) includes a rinsing step (at least one of the first rinsing step and second rinsing step) of rinsing the substrate with deionized water. In the rinsing step, ultrasonic waves are applied to the deionized water. By washing the substrate with washing liquid including deionized water to which ultrasonic waves are applied in a state vulnerable to adherence of microparticles due to the usage of acid washing liquid (rinse agent), adherence of microparticles to the substrate surface can be reduced. The treatment device shown in Fig. 6 can also be used in other washing steps.

### <Example 1>

In order to confirm the effect of the substrate surface treatment method of the present invention, samples set forth below were prepared and the impurity concentration at the surface of the sample was measured. The prepared samples, measurement procedure, and measured results will be described hereinafter.

### [Preparation of Sample]

First, the substrate preparation step (S10) was conducted. Specifically, indium phosphorus was prepared for the substrate formed of a compound semiconductor containing at least 5 mass % of indium. The surface substrate was mirror-finished to 0.08 nm ≤ Rms ≤ 0.25 nm (measured by AFM (Atomic Force Microscope) under 1 µm scan), where Rms represents the surface roughness measured based on JIS (Japan Industrial Standard) B0601.

Then, the washing step (S20) was executed. Specifically, diluted hydrochloric acid was prepared as the washing liquid having a pH of at least - 1 and not more than 3, and an oxidation-reduction potential E (mV) satisfying the relationship of - 0.08333x + 0.750 ≤ E ≤- 0.833x + 1.333, where x is the pH value. The pH value of the washing liquid was measured using a pH concentration meter that is calibrated using the standard solution of pH 6.97 and pH 4.0.

Then, the post-treatment step (S30) was executed. Specifically, epitaxial growth was conducted by a MOCVD (Metal-Organic Chemical Vapor Deposition) device on the substrate washed by the washing step.

### [Measurement Procedure]

The In/P ratio at the substrate surface subsequent to the washing step (S20) was measured for each obtained sample. Specifically, using an X-ray photoelectron spectrometer of PHI (ESCA Quantum 2000) with 10° as the photoelectron take-off angle (the angle between the surface of the sample and the analyzer axis), photoelectron data was collected for approximately 13 minutes with AlKα radiation at the transmission energy of 93eV. The collected data (count number) was corrected with the sensitivity factor to calculate the In/P ratio.

Further, the concentration of Si, C and O qualified as impurities at the interface between the substrate subsequent to the post-treatment step (S30) and the epitaxial layer was measured for each sample. Specifically, for the semiconductor substrate obtained subsequent to the post-treatment step (S30), the concentration of impurities at the interface between the former substrate and the epitaxial layer was measured using a magnetic sector type secondary ion mass spectrometer (SIMS) of CAMECA. Cs ions were sputtered from the surface side of the epitaxial layer and the output secondary ions counted with the spectrometer to obtain the concentration of each of Si, C and O.

### [Measured Result]

The results of the measurement are shown in Fig. 7. In Fig. 7, the horizontal axis represents the In/P ratio (unit:none) at the substrate surface subsequent to the washing step (S20), and the vertical axis represents the impurity concentration (unit:/cm²) at the interface between the substrate subsequent to the post-treatment step (S30) and the epitaxial layer.

It is appreciated from Fig. 7 that, by epitaxial growth on a substrate with the In/P ratio below 1.5 at the surface of the substrate subsequent to the washing step (S20), the impurity concentration at the interface subsequent to epitaxial growth can be reduced significantly in view of the impurity concentration of Si being below 2 x 10¹³ cm², the impurity concentration of C being below 2 x 10¹² cm², and the impurity concentration of O being below 2 x 10¹³ cm². It was found that the impurity concentration at the interface could be further reduced significantly by setting the In/P ratio at the substrate surface subsequent to the washing step (S20) to below 1.2.

According to the compound semiconductor substrate of Example 1 of the present invention, the proportion of Group III atoms/proportion of Group V atoms is below 1.5 for the substrate subsequent to the washing step (S20), based on XPS analysis with the photoelectron take-off angle of 10°. It was found that, when epitaxial growth was conducted on this substrate, the impurity concentration at the interface between the substrate and the epi layer could be reduced.

### <Example 2>

In order to confirm the effect of the substrate surface treatment method of the present invention, samples set forth below were prepared and the impurity concentration at the surface of the sample was measured.

### [Production of Sample of Example 2]

First, the substrate preparation step (S10) was executed. Specifically, an InP single crystal ingot obtained by the VB (Vertical Bridgeman) method was used as the substrate formed of a compound semiconductor containing at least 5 mass % of indium. The InP single crystal ingot was sliced with a diamond electrolytic deposited wire saw using an emulsion type water-soluble cutting agent. Then, peripheral grinding and chamfering were conducted using a metal bond grindstone, and the outer surface was mirror-finished with a rubber grindstone. After that, etching was conducted with aqua regina, followed by double-side lapping through the polishing particles of WA#3000 (product of Fujimi Incorporated). Next, following etching with aqua regina, the substrate was attached to a ceramic plate, and one side was polished by lapping. At this stage, for final finish, the substrate was polished with abrasives having dichloro isocyanuric acid, carbonate, phosphate, and sulfate mixed into acid colloidal silica to which organic acid was added, using a suede cloth.

Then, the pre-washing step (S40) was executed. Specifically, the substrate was detached from the ceramic plate, and the surface was rinsed with alkaline washing liquid including alcohol. Following removal of microparticles while applying ultrasonic waves in an organic alkali tub, wet-cleaning was carried out with deionized water.

Then, the first washing step (S20) was executed. Specifically, the substrate was washed for 30 seconds using 10% sulfuric acid with a pH of - 0.2 as the washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value. Next, the substrate was washed for 1 minute with deionized water as the first rinsing step.

Then, the second washing step (S50) was executed. Specifically, as the washing liquid having the pH adjusted to acidity of at least 2 and not more than 6.3 and with an oxidizing agent added, HF (hydrogen fluoride) was added as the pH adjuster into ultra deionized water such that the pH was adjusted to 2.4 and having 0.5% hydrogen peroxide solution diluted with deionized water added as the oxidizing agent. The substrate was washed for 10 seconds in a washing tub supplied with the washing liquid set forth above. Next, the substrate was wet-cleaned for 20 seconds with deionized water irradiated with ultrasonic waves, and then dried by a spin drier to remove moisture as the second rinsing step.

Then, the post-treatment step (S30) was executed. Specifically, epitaxial growth was conducted on the substrate by the MOCVD (Metal-Organic Chemical Vapor Deposition) method.

### [Production of Sample of Comparative Example 1]

The sample of Comparative Example 1 was produced in a manner basically similar to that of the sample of Example 2, provided that the first washing step (S20) is absent.

### [Measurement Procedure]

Following execution of the second washing step (S50), the In/P ratio at the surface substrate was analyzed by XPS, likewise Example 1. Further, after the post-treatment step (S30), the impurity concentration at the interface between the substrate surface and epitaxial layer was measured, likewise Example 1.

### [Measured Result]

The surface of the substrate corresponding to Example 1 had an In/P ratio of 1.3. The impurity concentration at the interface of Example 1 could be lowered to approximately 1/several times the impurity concentration at the interface of Comparative Example 1. It was found that the impurity concentration at the surface of the substrate could be reduced by including the first washing step (S20) in Example 2.

### <Example 3>

In order to confirm the effect of the substrate treatment method of the present invention, samples set forth below were prepared for measurement of the impurity (oxygen) concentration at the surface of the sample.

### [Production of Sample of Example 3]

The sample of Example 3 was produced in a manner basically similar to that of the sample of Example 2. Specifically, in the substrate preparation step (S10), InSb produced by zone melting was sliced with a wire saw, lapped with GC abrasives, and the surface was polished with zirconium oxide microparticle abrasives.

Then, the pre-washing step (S40) was executed. Specifically, the substrate was washed in 5% ammonium hydroxide solution irradiated with ultrasonic waves at 1 MHz, and then rinsed with deionized water for the wet-cleaning step.

Then, the first washing step (S20) was executed. Specifically, the substrate was washed for 30 seconds using 10% sulfuric acid with a pH of - 0.2 as the washing liquid having a pH of at least - 1 and not more than 3, and an oxidation-reduction potential E (mV) satisfying the relationship of - 0.08333x + 0.750 ≤ E < - 0.833x + 1.333, where x is the pH value. After that, the substrate was rinsed for 0.5 seconds with deionized water for the first rinsing step. Next, the substrate was dried to remove moisture by alcohol vapor drying.

Then, the post-treatment step (S30) was executed. Specifically, epitaxial growth was conducted on the substrate to grow an AlInSb layer as the epi layer on the substrate by MBE (Molecular Beam Epitaxy).

### [Production of Sample of Comparative Example 2]

The sample of Comparative Example 2 was produced in a manner basically similar to that of Example 3, provided that the first washing step (S20) was not executed on the substrate prepared at the substrate preparation step (S10) of Example 3, and the post-treatment process (step S30) was executed.

### [Measurement Procedure]

Subsequent to the post-treatment step (S30), the oxygen concentration qualified as impurities at the interface between the substrate surface and epitaxial layer in Example 3 and Comparative Example 2 was measured.

### [Measured Result]

The oxygen concentration at the interface of Example 3 was reduced to 1/10 the oxygen concentration at the interface of Comparative Example 2. It is found that the impurity (oxygen) concentration at the substrate surface can be reduced by applying the first washing step (S20) in accordance with Example 3.

### <Example 4>

In order to confirm the effect of the compound semiconductor substrate surface treatment method of the present invention, samples as set forth below were prepared for measurement of the impurity (silicon) concentration at the surface of the sample.

### [Production of Sample of Example 4]

The sample of Example 4 was produced in a manner basically similar to that of Example 2. Specifically, in the substrate preparation step (S 10), a 6-inch InP single crystal substrate produced by the pulling method was sliced with a wire saw using GC abrasives. Then, the outer surface of the substrate was chamfered and a V-shape notch was formed as mark to indicate the orientation of the outer surface. The substrate was subjected to double-face grinding with a planar grinder, and both sides were polished using an abrasive having an oxidizing agent added to colloidal alumina. After that, one side was polished with a bromine-methanol solution, followed by wet-cleaning.

Then, the first washing step (S20) was executed. Specifically, 5% sulfuric acid with a pH of 0.3 was prepared as the washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value. The substrate was washed for 30 seconds with this washing liquid using a sheet-fed wafer washer. Next, the rinsing step was executed to rinse the substrate for 30 seconds with deionized water.

Then, the second washing step (S50) was executed. Specifically, 2% HF solution was prepared as the washing liquid. The substrate was washed for 1 minute using this washing liquid and a sheet-fed wafer washer. Next, the substrate was rinsed for 30 minutes with deionized water at a higher speed of revolution. After that, the substrate was subjected to spin-drying to remove moisture.

Then, the post-treatment step (S30) was executed. Specifically, epitaxial growth was conducted on the substrate by the MOCVD method.

### [Production of Sample of Comparative Example 3]

A sample was produced in a manner basically similar to that of the sample of Example 4, provided that ammonium hydroxide solution was employed as the washing liquid in the first washing step (S20).

### [Measurement Procedure]

Likewise Example 2, the concentration of Si qualified as the impurities at the interface of the samples of Example 4 and Comparative Example 3 was measured.

### [Measured Result]

The Si concentration at the interface of Example 4 was reduced to 1/10 the Si concentration at the interface of Comparative Example 3. Thus, it is found that the impurity (silicon) concentration at the substrate surface can be reduced by including the first washing step (S20) according to Example 4.

### <Example 5>

In order to confirm the effect of the surface treatment method including the second washing step of the present invention, samples set forth below were prepared for measurement of the haze at the surface of the sample.

### [Preparation of Sample of Example 5]

For the sample of Example 5, first the substrate preparation step (S10) was executed. Specifically, an indium phosphorus (InP) mirror-surface substrate was prepared by VB growth as the substrate formed of a compound semiconductor containing at least 5 mass % of indium. The substrate had the surface mirror-finished to 0.08 nm ≤ Rms ≤ 0.15 nm (measured by AFM in 1 µm scan).

Then, the first washing step (S20) was executed. Specifically, diluted hydrochloric acid with a pH of 0.1 was prepared as the washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value. The pH of the washing liquid was measured using a pH concentration meter that is calibrated using the standard solution of pH 6.97 and pH 4.0.

The first washing step (S 10) using diluted hydrochloric acid was immediately succeeded by the second washing step (S50). In the second washing step (S50), HF (hydrogen fluoride) was added as the pH adjuster into ultra deionized water such that the pH was adjusted to 2.4 and having 0.5% hydrogen peroxide solution diluted with deionized water added as the oxidizing agent was produced as the washing liquid. The substrate was washed for 10 seconds with this washing liquid. Then, as the second rinsing step, the substrate was wet-cleaned for 20 seconds while megasonic ultrasonic waves (950 kHz) were applied in degassed deionized water. After that, the substrate was spin-dried to remove moisture by a spin drier with nitrogen gas blowing.

Then, the post-treatment step (S30) was executed. Specifically, epitaxial growth was conducted on the substrate washed by the second washing step (S50) with a MOCVD device.

### [Preparation of Sample of Example 6]

The sample of Example 6 was produced in a manner basically similar to that of Example 5, provided that the second washing step (S50) is absent. Specifically, in the first washing step (S10), diluted sulfuric acid with a pH of 0.1 was prepared as the washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value.

### [Preparation of Sample of Example 7]

The sample of Example 7 was produced in a manner basically similar to that of Example 5, provided that the second washing step (S50) is absent. Specifically, in the first washing step (S 10), diluted hydrochloric acid with a pH of 0.1 was prepared as the washing liquid having a pH of at least - 1 and not more than 3, and an oxidation-reduction potential E (mV) satisfying the relationship of - 0.08333x + 0.750 ≤ E ≤ - 0.833x + 1.333, where x is the pH value..

### [Measurement Procedure]

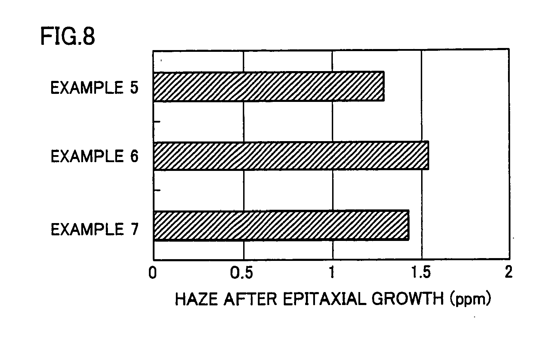

The haze subsequent to epitaxial growth was measured for the sample of each of Examples 5-7. The measurement was obtained using a surface inspection device under the trade name of Surfscan 6220 by KLA-Tencor. The results are shown in Fig. 8.

### [Measured Result]

It is appreciated from the measurement of haze subsequent to epitaxial growth shown in Fig. 8 that Example 5 having the second washing step (S50) added exhibited reduction in the haze than in Examples 6 and 7 absent of the second washing step. It was found that the haze at the surface of the substrate can be further reduced by including the second washing step (S50) in accordance with Example 5.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A surface treatment method of a compound semiconductor substrate comprising:
a substrate preparation step of preparing a substrate formed of a compound semiconductor containing at least 5 mass % of indium, and
a first washing step of washing said substrate for a washing duration of at least 3 seconds and not more than 60 seconds using washing liquid having a pH of at least - 1 and not more than 3, and an oxidation-reduction potential E (mV) satisfying a relationship of - 0.08333x + 0.750 ≤ E ≤ - 0.833x + 1.333, where x is a pH value.

2. The surface treatment method of a compound semiconductor substrate according to claim 1, wherein the pH of said washing liquid is adjusted to at least - 1 and not more than 1.5 in said first washing step.

3. The surface treatment method of a compound semiconductor substrate according to claim 1, wherein said first washing step includes a first rinsing step of rinsing said substrate with deionized water.

4. The surface treatment method of a compound semiconductor substrate according to claim 3, wherein ultrasonic waves are applied to said deionized water in said first rinsing step.

5. The surface treatment method of a compound semiconductor substrate according to claim 1, further comprising a second washing step of washing said substrate using washing liquid with the pH adjusted to acidity of at least 2 and not more than 6.3, and having an oxidizing agent added, after said first washing step.

6. The surface treatment method of a compound semiconductor substrate according to claim 5, wherein the washing duration in said second washing step is at least 5 seconds and not more than 60 seconds.

7. The surface treatment method of a compound semiconductor substrate according to claim 5, wherein said second washing step includes a second rinsing step of rinsing said substrate with deionized water.

8. The surface treatment method of a compound semiconductor substrate according to claim 7, wherein ultrasonic waves are applied to said deionized water in said second rinsing step.

9. The surface treatment method of a compound semiconductor substrate according to claim 1, comprising a pre-washing step of washing said substrate using alkaline washing liquid, prior to said first washing step.

10. The surface treatment method of a compound semiconductor substrate according to claim 9, wherein said pre-washing step includes a wet-cleaning step of rinsing said substrate with deionized water.

11. A fabrication method of a compound semiconductor comprising the steps of:
conducting the surface treatment method of a compound semiconductor substrate defined in claim 1, and
a post-treatment step of conducting film deposition on a surface of said substrate after said step of conducting the surface treatment method.

12. A compound semiconductor substrate (100) processed by the surface treatment method of a compound semiconductor substrate defined in claim 1,
wherein (a proportion of Group III atoms)/(a proportion of Group V atoms) is below 1.5 based on XPS analysis with a photoelectron take-off angle of 10° for a surface (101) of said compound semiconductor substrate (100).

13. A semiconductor wafer (200) comprising:
a substrate of a different type (201), and
the compound semiconductor substrate (100) defined in claim 12, formed on said substrate of a different type (201).
